# EUROPÄISCHE PATENTSCHRIFT

(11) **EP 1 363 131 B1**
(45) Veröffentlichungstag und Bekanntmachung des Hinweises auf die Patenterteilung: **20.08.2008**
(21) Anmeldenummer: 03010486.3
(22) Anmeldetag: 09.05.2003
(51) Int. Cl.: G01R 19/18

(54) **Messschaltung mit mehreren Zerhackern**
Measuring circuit with several choppers
Circuit de mesure avec plusieurs hacheurs

(30) Priorität: 14.05.2002 DE 10221426; 13.08.2002 DE 10237126
(43) Veröffentlichungstag der Anmeldung: 19.11.2003
(73) Patentinhaber: Isabellenhütte Heusler GmbH & Co.KG, 35683 Dillenburg (DE)
(72) Erfinder: Hetzler, Ullrich, Dr., 35688 Dillenburg-Oberscheld (DE)
(74) Vertreter: Heusler, Wolfgang

(56) Entgegenhaltungen:
- DE-A- 2 451 281
- US-A- 3 344 406
- US-A- 3 992 617
- US-A- 4 694 384

## Beschreibung

Die Erfindung betrifft eine Messschaltung, insbesondere ASIC zur Strom-, Spannungs- und Temperaturmessung (z.B. in einem Kfz-Bordnetz) gemäß dem Oberbegriff des Anspruchs 1.

Aus EP 1 030 185 A2 und US 6 489 693 B1 ist eine Messschaltung bekannt, die als ASIC (Application-Specific Integrated Circuit) ausgeführt ist und in einem Kfz-Bordnetz den Strom überwacht, um fehlerhafte Verbraucher zu identifizieren oder eine Überlastung der Batterie erkennen zu können.

Für die Messung analoger Signale werden unter anderem sogenannte Zerhacker- oder Chopper-Verstärker eingesetzt, die eine Verringerung des Eingangsoffsets und dessen Temperaturdrift sowie niederfrequenter Störgrößen ermöglichen. Derartige Zerhacker- oder Chopper-Verstärker bestehen aus einem eingangsseitigen Zerhacker (Chopper), einem nachgeschalteten Verstärker und einem ausgangsseitigen Demodulator, der das zerhackte und verstärkte Messsignal phasensynchron gleichrichtet.

Nachteilig an den bekannten Zerhacker-Verstärker-Schaltungen ist jedoch das unbefriedigende Rauschverhalten, die nicht vollständige Unterdrückung der Eingangs-Offset-Spannung und die Tatsache, dass diese Schaltungen nur als separate Verstärkerschaltungen verfügbar sind.

Aus DE 24 51 281 A1 ist eine rein analoge Messschaltung mit mehreren differentiellen Signaleingängen bekannt, wobei die einzelnen Signaleingänge eine differentielle Spannungsmessung ermöglichen und auf jeweils einen Zerhacker geschaltet sind. Ausgangsseitig sind die Zerhacker mit dem invertierenden bzw. nicht invertierenden Eingang eines Verstärkers verbunden, dem ein Demodulator nachgeschaltet ist.

Ferner ist aus US 3 344 406 eine Messschaltung bekannt, bei der mehrere analoge, einpolige Signaleingänge über jeweils einen EIN-/AUS-Schalter abgetastet werden, wobei die abgetasteten Signale von einem A/D-Wandler digitalisiert werden.

Der Erfindung liegt somit die Aufgabe zugrunde, eine physikalisch optimierte Zerhacker-Verstärker-Schaltung für mehrere einem gemeinsamen Ausgangskreis vorgeschaltete Eingangskanäle in das digitale Umfeld eines Analog-Digital-Wandlers so zu integrieren, dass vom Digitalteil keinerlei nachteilige Rückwirkungen auf den Verstärker auftreten und dass die Demodulation im digitalen Bereich erfolgt.

Die Aufgabe wird, ausgehend von der eingangs beschriebenen bekannten Zerhacker-Verstärker-Schaltung, durch die Merkmale des Anspruchs 1 gelöst.

Die Erfindung umfasst die allgemeine technische Lehre, in einer Zerhacker-Verstärker-Schaltung mit mehreren Signaleingängen für jeden Signaleingang jeweils einen Zerhacker vorzusehen. Bei einer Ausführung der erfindungsgemäßen Messschaltung als integrierte Schaltung sind die einzelnen Zerhacker zusammen mit der jeweiligen Eingangsschutzbeschaltung vorzugsweise direkt an dem Eingangskontakt auf dem Chip angebracht, um die Wirkung des Zerhackens zu optimieren.

In einer bevorzugten Ausführungsform der Erfindung weist die Messschaltung zusätzlich einen Temperatursensor auf, um die Temperaturabhängigkeit der Messung kompensieren zu können. Hierbei ist dem Temperatursensor vorzugsweise ebenfalls ein separater Zerhacker nachgeschaltet.

Vorzugsweise ist der Zerhacker selbst gleichzeitig der jeweilige Multiplexer, über den das Mess-Signal auf den Spannungsbus geschaltet wird. Von hier gelangt das Signal über weitere Multiplexerschaltungen zum Verstärker bzw. AD-Wandler.

In einer erfindungsgemäßen Ausführungsform der Erfindung ist zwischen dem Verstärker und dem Demodulator ein Analog/Digital-Wandler angeordnet, der das verstärkte Zerhackersignal in ein digitales Signal umwandelt, so dass die anschließende Demodulation digital erfolgt.

Vorzugsweise weist ein derartiger Analog/Digital-Wandler ein Filter mit einer programmierbaren Ordnungszahl auf, wobei neben der Ordnungszahl auch das Oversampling-Verhältnis und die Oversampling-Taktfrequenz des Analog/Digital-Wandlers vorzugsweise einstellbar sind.

Weiterhin ist in einer Ausführungsform der Erfindung vorgesehen, dass die Leitungsführung für alle Eingangssignale zweipolig ist, um eine differenzielle Messung zu ermöglichen, wodurch Offset, Drift, Rauschen und Einstreuung von außen verringert werden. Die gesamte Leitungsführung zwischen dem Signaleingang und dem Zerhacker, zwischen dem Zerhacker und dem Verstärker, zwischen dem Verstärker und AD-Wandler ist deshalb vorzugsweise zweipolig ausgeführt, wozu vorzugsweise eng beieinanderliegende Leiterbahnen verwendet werden.

Darüber hinaus ist in einer bevorzugten Ausführungsform der Erfindung vorgesehen, dass dem Verstärker ein Sigma-Delta-Wandler nachgeschaltet ist, der das zerhackte, verstärkte Messsignal in ein digitales Signal wandelt.

Ferner ist vorzugsweise eine Fühlerbruch-Überwachung vorgesehen, die eine Unterbrechung der eingangsseitig angeschlossenen Messleitungen bzw. -fühler erkennt. Hierzu ist vorzugsweise eine steuerbare Stromquelle vorgesehen, die auf mindestens einen der Signaleingänge schaltbar ist. Durch eine Spannungsmessung an dem jeweiligen Signaleingang kann dann erkannt werden, ob die eingangsseitig angeschlossenen Messleitungen bzw. -fühler unterbrochen sind.

Die Erfindung eignet sich besonders für die Messung sehr kleiner bipolarer Signale und hat den Vorteil, dass sie im Gegensatz zu vergleichbaren bekannten Wandlern für die Verarbeitung ähnlich kleiner Spannungen ohne zusätzlichen aufwändigen Vorverstärker und Multiplexer auskommt.

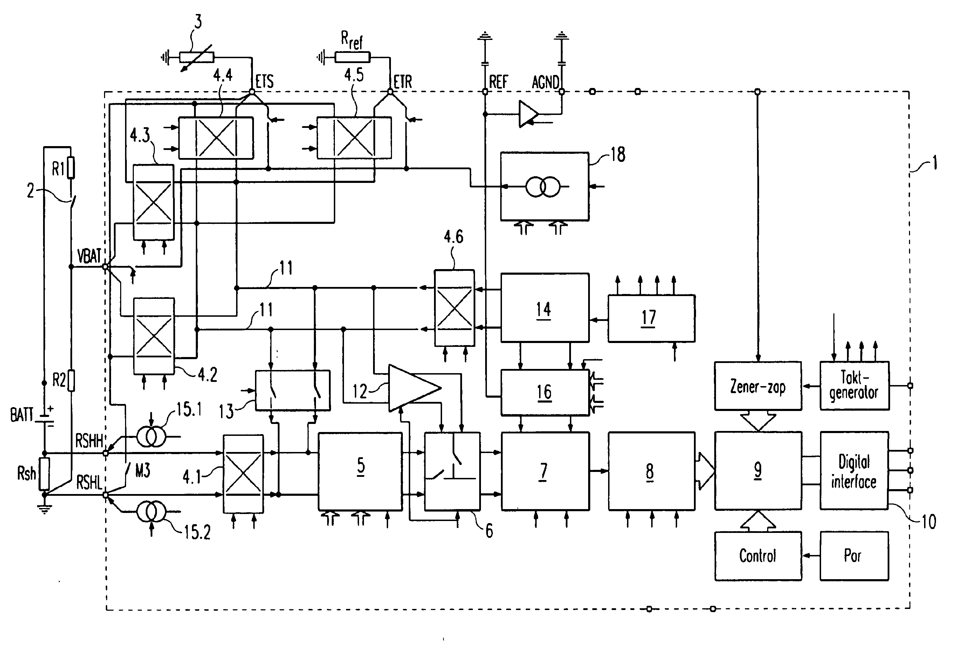

Andere vorteilhafte Weiterbildungen der Erfindung sind in den Unteransprüchen enthalten oder werden nachstehend zusammen mit der Beschreibung des bevorzugten Ausführungsbeispiels der Erfindung anhand der Zeichnung näher erläutert. Sie zeigt ein bevorzugtes Ausführungsbeispiel einer erfindungsgemäßen Messschaltung als Blockschaltbild.

Das Blockschaltbild verdeutlicht den schaltungstechnischen Aufbau einer erfindungsgemäßen Messschaltung 1, die in einem Kfz-Bordnetz zur Stromüberwachung verwendet werden kann.

Das Kfz-Bordnetz ist hierbei nur schematisch durch eine Batterie BATT, zwei Widerstände R1, R2, ein Schaltelement 2 sowie einen Messwiderstand Rsh dargestellt, wobei die über dem Messwiderstand Rsh abfallende Spannung den Strom in dem Kfz-Bordnetz wiedergibt.

Die Messschaltung 1 weist deshalb zwei Signaleingänge RSHH und RSHL auf, die eine differenzielle Spannungsmessung an dem Messwiderstand Rsh ermöglichen und deshalb mit den beiden Anschlüssen des Messwiderstandes Rsh verbunden sind.

Darüber hinaus weist die Messschaltung 1 einen Batteriespannungseingang VBAT auf, der mit dem Verbindungspunkt zwischen dem Schaltelement 2 und dem Widerstand R2 des Kfz-Bordnetzes verbunden ist.

Ferner verfügt die Messschaltung 1 über einen Signaleinang ETS, an den ein Sensor 3 mit einem variablen Widerstand angeschlossen ist.

Schließlich weist die Messschaltung 1 noch einen Signaleingang ETR auf, der über einen Widerstand Rref mit Masse verbunden ist.

Die an den Eingängen VBAT, ETS und ETR angeschlossenen Sensoren/Widerstände können über eine eingebaute und an jeden Eingang schaltbare, digital steuerbare und programmierbare Stromquelle 18 von der Mess-Schaltung angeregt werden. Der dadurch hervorgerufene Spannungsabfall kann dann am selben Eingang als Sensorsignal erfasst werden.

Die Signaleingänge RSHL, RSHH, VBAT, ETS und ETR sind jeweils einzeln mit Zerhackern 4.1-4.5 verbunden, die mit einer Frequenz von 20 kHz arbeiten. Die einzelnen Zerhacker 4.1-4.5 enthalten die Eingangsschutzbeschaltung und die Eingangsmultiplexer. Sie sind hierbei auf dem Chip der Messschaltung 1 unmittelbar an den Kontakten der Signaleingänge RSHL, RSHH, VBAT, ETS bzw. ETR angeordnet, um Offsetunterdrückung und Rauschverhalten zu optimieren.

Der Zerhacker 4.1 ist durch eine zweipolige Verbindung eingangsseitig direkt mit den beiden Signaleingängen RSHH und RSHL verbunden, wobei die zweipolige Leitungsführung Offset, Drift und Rauschen und die Empfindlichkeit auf externe Störfelder (EMV-Empfindlichkeit) verringert.

Der Zerhacker 4.3 ist ebenfalls durch eine zweipolige Leitung direkt mit den beiden Signaleingängen VBAT und ETS verbunden, während die Zerhacker 4.2, 4.4 und 4.5 über eine gemeinsame Masseleitung und ein Schaltelement M3 mit Masse verbunden sind (wobei mit Masse ein beliebiges gemeinsames Bezugspotenzial bei RSHL gemeint ist, auf das alle Signaleingänge bezogen sein können).

Ausgangsseitig ist der Zerhacker 4.1 mit einem Verstärker 5 verbunden, wobei der Verstärker 5 einen programmierbaren Verstärkungsfaktor aufweist.

Die anderen Zerhacker 4.2-4.5 sind ausgangsseitig mit einem zweipoligen Spannungsbus 11 verbunden, der über einen Verstärker 12 (Buffer) mit einem Multiplexer 6 verbunden ist. Der Multiplexer 6 kann also entweder das von dem Verstärker 5 verstärkte Signal des Zerhackers 4.1 oder das auf dem Spannungsbus 11 anliegende Signal eines der Zerhacker 4.2-4.5 an den Modulator 7 weiterleiten.

Darüber hinaus ist der Spannungsbus 11 über einen weiteren Multiplexer 13 mit dem Eingang des Verstärkers 5 verbunden. Der Verstärker 5 kann also eingangsseitig entweder das Signal des Zerhackers 4.1 oder das auf dem Spannungsbus 11 anliegende Signal aufnehmen.

Ein Digitalteil der Schaltung beinhaltet einen Steuermodus, der es erlaubt, sehr schnell zwischen diesen beiden Eingangskanälen des Verstärkers umzuschalten, womit eine Quasi-2-Kanal Messung mit nur einem A/D-Wandler ermöglicht wird. Die automatische Umschaltung erfolgt dabei zwischen der Strommessung (Zerhacker 4.1) und einer Messung auf dem Spannungsbus (Zerhacker 4.2 bis 4.6). Die Selektion und Einstellung der Messparameter (Verstärkung, Messgeschwindigkeit, Kanal u.a.) erfolgt dabei vor dem Messbeginn durch Beschreiben von internen Registern im digitalen Bereich.

Weiterhin weist die Messschaltung 1 einen Temperatursensor 14 auf, der ausgangsseitig mit einem weiteren Zerhacker 4.6 verbunden ist, wobei der Zerhacker 4.6 ausgangsseitig mit dem Spannungsbus 11 verbunden ist.

Der Ausgang des Verstärkers 5 ist über den Multiplexer 6 mit einem Sigma-Delta-Wandler, bestehend aus Modulator 7 und Dezimator 8, verbunden, der ausgangsseitig ein Digitalsignal an eine Digitalschaltung 9 abgibt. Die Demodulation bzw. das Dechopping erfolgt im digitalen Teil, also nicht wie bei herkömmlichen Zerhackerverstärkern im analogen Teil der Schaltung.

Während eines Messzyklus werden in jeder Polarität des Multiplexers vier (oder acht) Messungen durchgeführt, wovon wegen der unvermeidlichen Einschwingvorgänge des analogen Teils nur der letzte Wert für die digitale Berechnung des offset-kompensierten Messwertes benutzt wird, so dass Einschwingeffekte vollständig vermieden werden. Ein aktualisierter voll offset-kompensierter Messwert steht bei kontinuierlicher Messung bereits nach der einfachen Wandlungszeit zur Verfügung, da der jeweils letzte Messwert mit anderem Vorzeichen für die digitale Berechnung benutzt werden kann.

Die Digitalschaltung 9 ist darüber hinaus mit einer digitalen Schnittstelle 10 verbunden, über die das Messsignal ausgegeben werden kann.

Darüber hinaus ermöglicht die Messschaltung 1 die Erkennung einer Unterbrechung bzw. eines Bruchs der Anschlussleitungen, die an den beiden Signaleingängen RSHH und RSHL angeschlossen sind. Hierzu weist die Messschaltung 1 zwei schaltbare Stromquellen 15.1, 15.2 auf, die an die beiden Signaleingänge RSHH und RSHL angeschlossen sind und einen Messstrom abgeben können. Durch eine Messung der differenziellen Spannung an den beiden Signaleingängen RSHH und RSHL kann dann ermittelt werden, ob die Anschlussleitungen unterbrochen bzw. defekt sind.

In gleicher Weise können die Anschlussleitungen an den Eingängen VBAT, ETR, ETS auf Bruch untersucht werden durch Aufschalten der internen Stromquelle 17.

Schließlich ermöglicht die Messschaltung 1 eine analoge Verschiebung des Eingangssignals auf etwa die halbe Versorgungsspannung, wodurch es gelungen ist, Eingangsspannungen mit positiven und negativen Werten bis +/- 0,7 V mit gleicher Güte zu messen. Hierzu weist die Messschaltung 1 eine Trimmschaltung 16 und 17 auf, die ausgangsseitig mit dem Modulator 7 und eingangsseitig mit einem Referenzeingang REF und einem analogen Masseeingang AGND verbunden ist.

Diese Schaltung beinhaltet auch eine Präzisionsreferenzspannung, deren Absolutwert und Temperaturkoeffizient über die digitale Schnittstelle getrimmt werden kann.

Die Messschaltung beinhaltet außerdem einen sog. "Sleep-Modus", bei dem alle Funktionsgruppen zur Reduzierung der Stromquelle abgeschaltet sind. Der Versorgungsstrom liegt in diesem Fall unter 100 µA.

Eine Besonderheit stellt der in diesem Modus aktivierbare "Aktive Wake-Up-Modus" dar. Hierbei wird über einen im digitalen Bereich plazierten internen Oszillator/Timer die Messschaltung ca.1 mal pro sec aktiviert und eine vorprogrammierte Messung durchgeführt. Wird dabei eine Überschreitung eines ebenfalls vorprogrammierten Grenzwertes festgestellt, wird eine Ausgangsleitung aktiviert, über die wiederum eine externe übergeordnete Elektronikbaugruppe geweckt werden kann. Wird kein Fehler festgestellt, kehrt die Schaltung wieder in den "Sleep-Modus" bis zur nächsten Aktivierung zurück.

Die vorstehend beschriebene Messschaltung kann vorteilhaft zur Messung des von einer Fahrzeugbatterie zu den angeschlossenen Verbrauchern fließenden Gesamtstroms und/oder des Ladestroms der Fahrzeugbatterie verwendet werden, um in der in EP 1 030 185 A1 und US 6 489 693 B1 beschriebenen Weise die einzelnen Verbraucher zu überwachen bzw. die Batterieströme im Sinne einer Verlängerung der Lebensdauer der Fahrzeugbatterie zu steuern. Auf die Offenbarung dieser Dokumente wird hier Bezug genommen. Demgemäß kann die Messschaltung 1 vorteilhaft auf einer Oberfläche eines aus einer Metalllegierung bestehenden Messwiderstands wie z.B. des Widerstands Rsh montiert oder angeordnet sein, zweckmäßig mit wärmeleitender Verbindung.

Die Erfindung ist nicht auf den vorstehend beschriebenen ASIC als bevorzugtes Ausführungsbeispiel beschränkt. Vielmehr ist eine Vielzahl von Varianten und Abwandlungen denkbar, die ebenfalls von dem Erfindungsgedanken Gebrauch machen und deshalb in den Schutzbereich fallen.

## Patentansprüche

1. Messschaltung, insbesondere ASIC zur Strom- und Spannungsmessung, mit
a) mehreren Signaleingängen (RSHH-RSHL, VBAT-RSHL, ETS-RSHL, ETR-RSHL, VBAT-ETS) zur Aufnahme jeweils eines analogen Eingangssignals,
b) mehreren Zerhackeranordnungen (4.1-4.6), wobei jedem Signaleingang (RSHH-RSHL, VBAT-RSHL, ETS-RSHL, ETR-RSHL, VBAT-ETS) jeweils eine Zerhackeranordnung (4.1-4.6) nachgeschaltet ist,
c) einer zweipoligen Leitungsführung zwischen den einzelnen Signaleingängen (RSHH-RSHL, VBAT-RSHL, ETS-RSHL, ETR-RSHL, VBAT-ETS) und den Zerhackeranordnungen (4.1-4.5),
d) einem Verstärker (5), wobei die Zerhackeranordnungen (4.1-4.6) ausgangsseitig mit dem Verstärker (5) verbunden sind,
e) einem Signalausgang (10) zur Ausgabe eines Ausgangssignals,
**gekennzeichnet durch**
f) eine digitale Signalverarbeitungseinheit (9) mit einem digitalen Demodulator (9) sowie
g) einen Analog/Digital-Wandler (7, 8),
h) wobei der Analog/Digital-Wandler (7, 8) zwischen dem Verstärker (5) und dem Demodulator (9) angeordnet ist,
i) wobei die digitale Signalverarbeitungseinheit (9) zwischen dem Analog/Digital-Wandler (7, 8) und dem Signalausgang (10) angeordnet ist,
j) wobei der Analog/Digital-Wandler (7, 8) zum Umwandeln des verstärkten Zerhackersignals in ein digitales Signal, geeignet ist
k) wobei die digitale Signalverarbeitungseinheit zum Dechopping geeignet ist.

2. Messschaltung nach Anspruch 1, **dadurch gekennzeichnet, dass** die Eingangssignale der Signaleingänge (RSHH, VBAT, ETS, ETR) in Bezug auf ein gemeinsames Bezugspotential (RSHL) gemessen werden.

3. Messschaltung nach Anspruch 1 oder 2, **dadurch gekennzeichnet, dass** der Verstärker (5) durch automatische Steuerung zwischen zwei Eingangskanälen (4.1, 11) umschaltbar ist, so dass ihm zwei unterschiedliche Messsignale zuführbar sind.

4. Messschaltung nach Anspruch 3, **dadurch gekennzeichnet, dass** dem Verstärker (5) abwechselnd ein Strommesssignal (4.1) und ein Spannungsmesssignal (11) zuführbar sind.

5. Messschaltung nach mindestens einem der vorhergehenden, **dadurch gekennzeichnet, dass** zur Temperaturerfassung ein Temperatursensor (14) vorgesehen ist, wobei dem Temperatursensor (14) eine Zerhackeranordnung (4.6) nachgeschaltet ist.

6. Messschaltung nach einem der vorhergehenden Ansprüche, **dadurch gekennzeichnet, dass** der Analog/Digital-Wandler (7, 8) ein Filter mit einer programmierbaren Ordnungszahl (8) aufweist.

7. Messschaltung nach mindestens einem der vorhergehenden Ansprüche, **dadurch gekennzeichnet, dass** mehrere je einem Signaleingang (RSHH, VBAT, ETS, ETR) zugeordnete, jeweils separat aktivierbare Zerhackeranordnungen (4.1-4.6) selbst als Multiplexer wirkend und/oder über mindestens einen Multiplexer (6, 13) mit dem Verstärker (5) oder mit dem Analog/Digital-Wandler (7, 8) verbindbar sind.

8. Messschaltung nach mindestens einem der vorhergehenden Ansprüche, **dadurch gekennzeichnet, dass** mehrere Zerhackeranordnungen (4.2-4.6) durch einen Spannungsbus (11) miteinander verbunden sind.

9. Messschaltung nach mindestens einem der vorhergehenden Ansprüche, **gekennzeichnet durch** je eine zweipolige Leitungsführung zwischen den Zerhackeranordnungen (4.1-4.5) und dem Verstärker (5) und/oder zwischen dem Verstärker (5) und dem Demodulator (9) und/oder zwischen dem Demodulator (9) und dem Signalausgang.

10. Messschaltung nach mindestens einem der vorhergehenden Ansprüche, **dadurch gekennzeichnet, dass** dem Verstärker (5) ein Sigma-Delta-Modulator (7) nachgeschaltet ist.

11. Messschaltung nach mindestens einem der vorhergehenden Ansprüche, **gekennzeichnet durch** eine steuerbare erste Stromquelle (15.1, 15.2), die auf mindestens einen der Signaleingänge (RSHH, RSHL) schaltbar ist.

12. Messschaltung nach mindestens einem der vorhergehenden Ansprüche, **gekennzeichnet durch** eine steuerbare zweite Stromquelle (18), die auf mindestens einen der Ausgänge (ETR, ETS und VBAT) schaltbar ist, um externe Sensoren anzuregen.

13. Messschaltung nach mindestens einem der vorhergehenden Ansprüche, **dadurch gekennzeichnet, dass** der Verstärker (5) eine einstellbare Verstärkung aufweist.

14. Messschaltung nach mindestens einem der vorhergehenden Ansprüche, **dadurch gekennzeichnet, dass** jede die Zerhackeranordnung (4.1-4.6) eine Frequenz im Bereich von 5 kHz bis 50 kHz aufweist.

15. Messschaltung nach Anspruch 14, **dadurch gekennzeichnet, dass** die jede Zerhackeranordnung (4.1-4.6) eine Frequenz von 20 kHz aufweist.

16. Messschaltung nach mindestens einem der vorhergehenden Ansprüche, **gekennzeichnet durch** eine digitale Schnittstelle (10) zur Einstellung mindestens eines Betriebsparameters der Messschaltung (1).

17. Messschaltung nach Anspruch 16, **dadurch gekennzeichnet, dass** der einstellbare Betriebsparameter ein Absolutwert und/oder ein Temperaturkoeffizient einer Referenzspannung ist.

18. Messschaltung nach mindestens einem der vorhergehenden Ansprüche, **gekennzeichnet durch** einen Oszillator und/oder einen Zeitgeber zur internen Takterzeugung.

19. Messschaltung nach mindestens einem der vorhergehenden Ansprüche, **dadurch gekennzeichnet, dass** die jede Zerhackeranordnung (4.1-4.6), der Verstärker (5), die digitale Signalverarbeitungseinheit, der Multiplexer (6, 13) und/oder der Analog/Digital-Wandler (7, 8) zur Reduzierung des Stromverbrauchs abschaltbar sind.

20. Messschaltung nach mindestens einem der vorhergehenden Ansprüche, **gekennzeichnet durch** einen Betriebsmodus, in dem die Messschaltung (1) in vorgegebenen Zeitabständen eine Messung durchführt, eine Überprüfung eines vorgegebenen Schwellwertes vornimmt und im gegebenen Fall ein externes Gerät aktiviert.

21. Messschaltung nach mindestens einem der vorhergehenden Ansprüche, **gekennzeichnet durch** eine Ausführung als integrierte Schaltung.

22. Messschaltung nach Anspruch 21 mit einem Messwiderstand (Rsh), der mindestens einem der Signaleingänge (RSHH) vorgeschaltet ist, **dadurch gekennzeichnet, dass** die integrierte Schaltung (1) auf dem Messwiderstand (Rsh) montiert ist.

## Claims

1. A measuring circuit, particularly an ASIC for current and voltage measurement including
a) a plurality of signal inputs (RSHH-RSHL, VBAT-RSHL, ETS-RSHL, ETR-RSHL, VBAT-ETS) for receiving a respective analogue input signal,
b) a plurality of choppers (4.1 - 4.6), wherein a respective chopper (4.1 - 4.6) is connected to the output side of each signal input (RSHH-RSHL, VBAT-RSHL, ETS-RSHL, ETR-RSHL, VBAT-ETS),
c) a two-pole wiring arrangement between the individual signal inputs (RSHH-RSHL, VBAT-RSHL, ETS-RSHL, ETR-RSHL, VBAT-ETS) and the choppers (4.1 - 4.5),
d) an amplifier (5), wherein the choppers (4.1 - 4.6) are connected on the output side to the amplifier (5),
e) a signal output (10) supplying an output signal,
**characterised by**
f) a digital signal processing unit (9) with a digital demodulator (9) and
g) an analogue/digital converter (7, 8),
h) wherein the analogue/digital converter (7, 8) is arranged between the amplifier (5) and the demodulator (9),
i) wherein the digital signal processing unit (9) is arranged between the analogue/digital converter (7, 8) and the signal output (10),
j) wherein the analogue/digital converter (7, 8) is suitable for converting the amplified chopper signal into a digital signal,
k) wherein the digital signal processing unit is suitable for dechopping.

2. A measuring circuit as claimed in claim 1, **characterised in that** the input signals at the signal inputs (RSHH-RSHL, VBAT-RSHL, ETS-RSHL, ETR-RSHL, VBAT-ETS) are measured with respect to a common reference voltage (RSHH, VBAT, ETS, ETR).

3. A measuring circuit as claimed in claim 1 or 2, **characterised in that** the amplifier (5) may be switched over by an automatic control between two input channels (4.1, 11) so that two different measurement signals may be supplied to it.

4. A measuring circuit as claimed in claim 3, **characterised in that** a current measurement signal (4.1) and a voltage measurement signal (11) are suppliable alternately to the amplifier (5).

5. A measuring circuit as claimed in at least one of the preceding claims, **characterised in that** a temperature sensor is provided for temperature detection, wherein a chopper (4.6) is connected to the outlet side of the temperature sensor (14).

6. A measuring circuit as claimed in at least one of the preceding claims, **characterised in that** the analogue/digital converter (7, 8) includes a filter with a programmable order (8).

7. A measuring circuit as claimed in at least one of the preceding claims, **characterised in that** a plurality of choppers (4.1 - 4.6), which are associated with a respective signal input (RSHH, VBAT, ETS, ETR) and are separately activatable are connectable to the amplifier (5) or to the analogue/digital converter (7, 8) acting themselves as multipliers and/or via at least one multiplexer (6, 13).

8. A measuring circuit as claimed in at least one of the preceding claims, **characterised in that** a plurality of choppers (4.2 - 4.6) are connected together by a voltage bus (11).

9. A measuring circuit as claimed in at least one of the preceding claims, **characterised by** a respective two-pole wiring arrangement between the choppers (4.1 - 4.5) and the amplifier (5) and/or between the amplifier (5) and the demodulator (9) and/or between the demodulator (9) and the signal output.

10. A measuring circuit as claimed in at least one of the preceding claims, **characterised in that** a sigma-delta modulator (7) is connected to the output side of the amplifier (5).

11. A measuring circuit as claimed in at least one of the preceding claims, **characterised by** a controllable first current source (15.1, 15.2), which is switchable onto at least one of the signal inputs (RSHH, RSHL).

12. A measuring circuit as claimed in at least one of the preceding claims, **characterised by** a controllable second current source (18), which is switchable onto at least one of the outputs (ETR, ETS and VBAT) in order to excite external sensors.

13. A measuring circuit as claimed in at least one of the preceding claims, **characterised in that** the amplifier (5) has adjustable amplification.

14. A measuring circuit as claimed in at least one of the preceding claims, **characterised in that** each chopper (4.1 - 4.6) has a frequency in the range of 5 kHz to 50 kHz.

15. A measuring circuit as claimed in at least one of the preceding claims, **characterised in that** each chopper (4.1 - 4.6) has a frequency of 20 kHz.

16. A measuring circuit as claimed in at least one of the preceding claims, **characterised by** a digital interface (10) for adjusting at least one operating parameter of the measuring circuit (1).

17. A measuring circuit as claimed claim 16, **characterised in that** the adjustable operating parameter is an absolute value and/or a temperature coefficient of a reference voltage.

18. A measuring circuit as claimed in at least one of the preceding claims, **characterised by** an oscillator and/or a time signal transmitter for internal timing generation.

19. A measuring circuit as claimed in at least one of the preceding claims, **characterised in that** each chopper (4.1 - 4.6), the amplifier (5), the digital signal processing unit, the multiplexer (6, 13) and/or the analogue/digital converter (7, 8) may be switched off to reduce current consumption.

20. A measuring circuit as claimed in at least one of the preceding claims, **characterised by** an operating mode, in which the measuring circuit (1) performs a measurement, carries out a check of a pre-determined threshold value and, optionally, activates an external device at pre-determined time intervals.

21. A measuring circuit as claimed in at least one of the preceding claims, **characterised by** a construction in the form of an integrated circuit.

22. A measuring circuit as claimed in claim 21 with a measuring resistance (Rsh), which is connected on the input side of at least one of the signal inputs (RSHH), **characterised in that** the integrated circuit (1) is mounted on the measuring resistor (Rsh).

## Revendications

1. Circuit de mesure, en particulier ASIC pour la mesure de courant et de tension, avec
a) plusieurs entrées de signaux (RSHH-RSHL, VBAT-RSHL, ETS-RSHL, ETR-RSHL, VBAT-ETS) pour la réception d'un signal d'entrée analogique,
b) plusieurs dispositifs à hacheurs (4.1-4.6), chaque dispositif à hacheurs (4.1-4.6) étant monté en aval de chaque entrée de signaux (RSHH-RSHL, VBAT-RSHL, ETS-RSHL, ETR-RSHL, VBAT-ETS),
c) un dispositif de guidage de ligne bipolaire entre les différentes entrées de signaux (RSHH-RSHL, VBAT-RSHL, ETS-RSHL, ETR-RSHL, VBAT-ETS) et les dispositifs à hacheurs (4.1-4.5),
d) un amplificateur (5), les dispositifs à hacheurs (4.1-4.6), étant reliés à l'amplificateur (5) du côté sortie,
e) une sortie de signaux (10) pour l'émission d'un signal de sortie,
**caractérisé par**
f) une unité numérique de traitement de signaux (9) avec un démodulateur numérique (9), ainsi que
g) un convertisseur analogique/numérique (7, 8),
h) le convertisseur analogique/numérique (7, 8) étant placé entre l'amplificateur (5) et le démodulateur (9),
i) l'unité numérique de traitement de signaux (9) étant placée entre le convertisseur analogique/numérique (7, 8) et la sortie de signaux (10),
j) le convertisseur analogique/numérique (7, 8) étant adapté pour la conversion du signal de hacheur amplifié en un signal numérique,
k) l'unité numérique de traitement de signaux étant adaptée pour le dé-hachage.

2. Circuit de mesure selon la revendication 1, **caractérisé en ce que** les signaux d'entrée des entrées de signaux (RSHH, VBAT, ETS, ETR) sont mesurés en référence à un potentiel de référence commun (RSHL).

3. Circuit de mesure selon la revendication 1 ou 2, **caractérisé en ce que** l'amplificateur (5) est commutable entre deux canaux d'entrée (4.1, 11) par une commande automatique, de sorte que deux signaux de mesure différents peuvent luis être envoyés.

4. Circuit de mesure selon la revendication 3, **caractérisé en ce qu'**un signal de mesure de courant (4.1) et un signal de mesure de tension (11) peuvent être envoyés alternativement à l'amplificateur (5).

5. Circuit de mesure selon au moins l'une quelconque des revendications précédentes, **caractérisé en ce qu'**il est prévu un capteur de température (14) pour la détection de température, un dispositif à hacheurs (4.6) étant monté en aval du capteur de température (14) ;

6. Circuit de mesure selon l'une quelconque des revendications précédentes, **caractérisé en ce que** le convertisseur analogique/numérique (7, 8) comporte un filtre avec un numéro d'ordre programmable (8).

7. Circuit de mesure selon au moins l'une quelconque des revendications précédentes, **caractérisé en ce que** plusieurs dispositifs à hacheurs (4.1-4.6) associés chacun à une entrée de signaux (RSHH, VBAT, ETS, ETR), activables séparément, peuvent être raccordés à l'amplificateur (5) ou au convertisseur analogique/numérique (7, 8) en fonctionnant eux-mêmes comme multiplexeurs et/ou au moyen d'au moins un multiplexeur (6, 13).

8. Circuit de mesure selon au moins l'une quelconque des revendications précédentes, **caractérisé en ce que** plusieurs dispositifs à hacheurs (4.2-4.6) sont reliés les uns aux autres par un bus de tension (11).

9. Circuit de mesure selon au moins l'une quelconque des revendications précédentes, **caractérisé par** un dispositif de guidage de ligne bipolaire entre les dispositifs à hacheurs (4.1-4.6) et l'amplificateur (5) et/ou entre l'amplificateur (5) et le démodulateur (9) et/ou entre le démodulateur (9) et la sortie de signaux.

10. Circuit de mesure selon au moins l'une quelconque des revendications précédentes, **caractérisé en ce qu'**un modulateur sigma-delta (7) est monté en aval de l'amplificateur (5).

11. Circuit de mesure selon au moins l'une quelconque des revendications précédentes, **caractérisé par** une première source de courant commandée (15.1, 15.2) qui est commutable sur au moins l'une des entrées de signaux (RSHH, RSHL).

12. Circuit de mesure selon au moins l'une quelconque des revendications précédentes, **caractérisé par** une seconde source de courant commandée (18) qui est commutable sur au moins l'une des sorties (ETR, ETS et VABT) pour exciter des capteurs externes.

13. Circuit de mesure selon au moins l'une quelconque des revendications précédentes, **caractérisé en ce que** l'amplificateur (5) présente une amplification réglable.

14. Circuit de mesure selon au moins l'une quelconque des revendications précédentes, **caractérisé en ce que** le dispositif à hacheurs (4.1-4.6) présente une fréquence dans la plage comprise entre 5 kHz et 50 kHz.

15. Circuit de mesure selon la revendication 14, **caractérisé en ce que** le dispositif à hacheurs (4.1-4.6) présente une fréquence de 20 kHz.

16. Circuit de mesure selon au moins l'une quelconque des revendications précédentes, **caractérisé par** une interface numérique (10) pour le réglage d'au moins un paramètre de fonctionnement du circuit de mesure (1).

17. Circuit de mesure selon la revendication 16, **caractérisé en ce que** le paramètre de fonctionnement réglable est une valeur absolue et/ou un coefficient de température d'une tension de référence.

18. Circuit de mesure selon au moins l'une quelconque des revendications précédentes, **caractérisé par** un oscillateur et/ou un générateur de cadence pour la génération d'une cadence interne.

19. Circuit de mesure selon au moins l'une quelconque des revendications précédentes, **caractérisé en ce que** chaque dispositif à hacheurs (4.1-4.6), l'amplificateur (5), l'unité numérique de traitement de signaux, le multiplexeur (6, 13) et/ou le convertisseur analogique/numérique (7, 8) peuvent être mis hors service pour la réduction de la consommation de courant.

20. Circuit de mesure selon au moins l'une quelconque des revendications précédentes, **caractérisé par** un mode de fonctionnement dans lequel le circuit de mesure (1) effectue une mesure à des intervalles de temps prédéterminés, une vérification d'une valeur seuil prédéterminée et, le cas échéant, active un appareil externe.

21. Circuit de mesure selon au moins l'une quelconque des revendications précédentes, **caractérisé par** un mode de réalisation sous forme de circuit intégré.

22. Circuit de mesure selon la revendication 21, avec une résistance de mesure (Rsh) qui est montée en amont d'au moins l'une des entrées de signaux (RSHH), **caractérisé en ce que** le circuit intégré (1) est monté sur la résistance de mesure (Rsh).
